# EUROPEAN PATENT APPLICATION

(11) **EP 2 202 882 A1**
(43) Date of publication of application: **30.06.2010**
(21) Application number: 08792095.5
(22) Date of filing: 01.08.2008
(51) Int. Cl.: H03H 9/145, H03H 9/25, H03H 9/64

(54) **SURFACE ACOUSTIC WAVE RESONATOR AND LADDER TYPE FILTER**

(30) Priority: 18.10.2007 JP 2007271606
(71) Applicant: Murata Manufacturing Co. Ltd., Nagaokakyo-shi, Kyoto 617-8555 (JP)
(72) Inventor: TANAKA, Nobuhira, Nagaokakyo-shi Kyoto 617-8555 (JP)
(74) Representative: Thévenet, Jean-Bruno
(86) International application number: PCT/JP2008/063882
(87) International publication number: WO 2009/050932

(57) **Abstract**

To provide a surface acoustic wave resonator that can sufficiently increase the impedance at the anti-resonance frequency and can improve filter characteristics in a case where a ladder-type filter is formed. A surface acoustic wave resonator (1) where the cross widths of an IDT electrode (3) are weighted so that the cross widths are made smaller as they move outward in the surface acoustic wave propagation direction, an inner edge (11a) of a first bus bar (11) has inclined portions (11a1 and 11a2) that are inclined so that the inner edge (11a) is disposed a predetermined distance away from an envelope portion (B1) adjacent to the first bus bar (11), an inner edge (12a) of a second bus bar has inclined portions (12a1 and 12a2) that are inclined so manner that the inner edge (12a) is disposed a predetermined distance away from an envelope portion (B2) adjacent to the second bus bar (12), and if the sum of the numbers of electrode fingers and dummy electrodes that a straight line extending from the tip of at least one of electrode fingers (13) and electrode fingers (15) in the surface acoustic wave propagation direction crosses before reaching the edge (11a) of the first bus bar or the edge (12a) of the second bus bar is represented by N, the N is 11 or more.

## Description

### Technical Field

The present invention relates to a surface acoustic wave resonator where reflectors are disposed adjacent to both ends in the surface acoustic wave propagation direction, of an IDT electrode, and a ladder-type filter using the surface acoustic wave resonator. In particular, the invention relates to a surface acoustic wave resonator where cross widths of an IDT electrode are weighted, and a ladder-type filter using the surface acoustic wave resonator.

### Background Art

Surface acoustic wave resonators have been widely used in communication devices, such as cellular phones, so as to form resonators or filters.

For example, Patent Document 1 below discloses a surface acoustic wave resonator 1001 shown in Fig. 14. The surface acoustic wave resonator 1001 is formed by forming an illustrated electrode structure on a piezoelectric substrate. The surface acoustic wave resonator 1001 is a surface acoustic wave resonator using Love waves having an electromechanical coupling coefficient k2 larger than that of Rayleigh waves.

In the surface acoustic wave resonator 1001, an IDT electrode 1002 is formed on the piezoelectric substrate. The IDT electrode 1002 includes a bus bar 1003 and a bus bar 1004 disposed as opposed to the bus bar 1003. The bus bar 1003 has a bus bar portion 1003a extending as inclined toward a direction forming an angle of θ with the surface acoustic wave propagation direction and a bus bar portion 1003b extending while forming an angle of -θ with the surface acoustic wave propagation direction and connected to the bus bar portion 1003a.

Similarly, a second bus bar 1004 has a bus bar portion 1004a extending while forming an angle of -θ with the surface acoustic wave propagation direction and a bus bar portion 1004b connected to the bus bar portion 1004a and extending in a direction forming an angle of θ with the surface acoustic wave propagation direction.

The bus bar portions 1003a and 1003b and bus bar portions 1004a and 1004b form a rough rhombus.

Multiple electrode fingers 1005 extend from the bus bar portions 1003a and 1003b toward the bus bar portions 1004a and 1004b. Dummy electrodes 1006 are disposed as opposed to the tips of the electrode fingers 1005 with gaps therebetween. Ends of the dummy electrodes 1006 are connected to the second bus bar 1004 and the other ends thereof are opposed to the electrode fingers 1005 with the above-mentioned gaps therebetween.

Similarly, multiple electrode fingers 1007 having ends connected to the second bus bar 1004 and the other ends extending toward the first bus bar 1003 are disposed. Dummy electrodes 1008 are disposed as opposed to the tips of the electrode fingers 1007 with gaps therebetween in the length direction of the electrode fingers. Ends of the dummy electrodes 1008 are connected to the first bus bar 1003 and the other ends thereof are opposed to the electrode fingers 1007 with the above-mentioned gaps therebetween.

The electrode fingers 1005 and electrode fingers 1007 are alternately disposed in the surface acoustic wave propagation direction. Also, in the above-mentioned IDT electrode 1002, the cross widths are weighted. On the basis of this cross-width weighting, the cross width located at the center in the surface acoustic wave propagation direction is made largest and cross widths located more outward in the surface acoustic wave propagation direction are made smaller.

In the surface acoustic wave resonator 1001, the cross width of the above-mentioned smallest cross width portion is made zero. Areas where only the dummy electrodes 1006 and 1008 exist are provided most outside in the surface acoustic wave propagation direction.

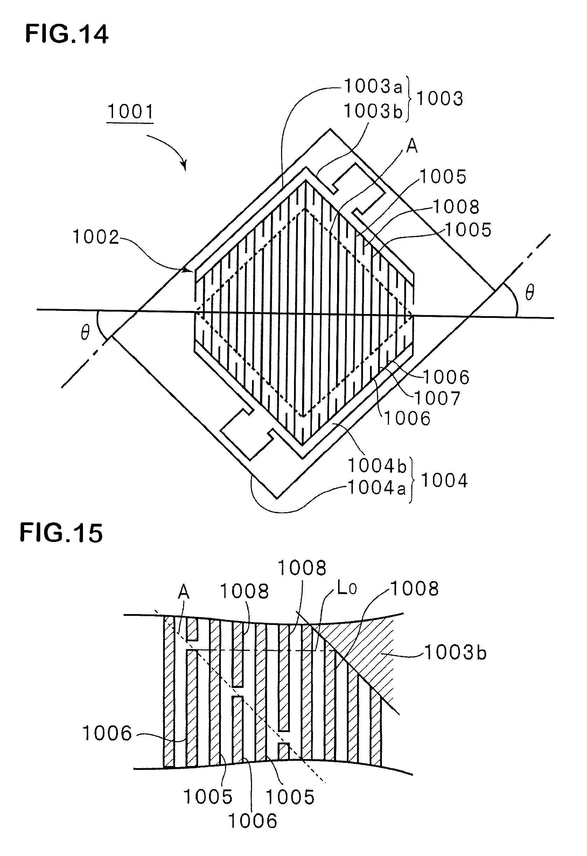

A feature of the surface acoustic wave resonator 1001 is that the cross widths are weighted as described above and an envelope A obtained by the above-mentioned cross width weighting is in parallel with the inner edges of the bus bar portions 1003a, 1003b, 1004a, and 1004b. In other words, the inner edges of the bus bar portions 1003a to 1004b are disposed in parallel with the envelope. That is, the inner edges of the bus bar portions 1003a to 1004b are inclined while forming an angle of θ or -θ with the surface acoustic wave propagation direction. For this reason, resonance due to anharmonic higher-order mode does not readily occur. This can reduce spurious waves. Particularly, in Patent Document 1, portions between the above-mentioned envelope and the inner edges of the bus bars extending in parallel with the envelope function as reflectors. For this reason, for example, as shown by a straight line L in Fig. 15, an excited surface acoustic wave crosses, for example, five electrode fingers before reaching the inner edge of the bus bar portion 1003b. Since these five electrode fingers function as reflectors, spurious waves can be restrained effectively, allowing downsizing.
[Patent Document 1] Japanese Unexamined Patent Application Publication No. 2000-286663.

### Disclosure of Invention

Surface acoustic wave resonators are used to form oscillation circuits, filters, and the like. To form a filter circuit, multiple surface acoustic wave resonators are typically connected. For example, in a ladder-type filter including multiple surface acoustic wave resonators, at least one surface acoustic wave resonator is connected to a series arm and at least one surface acoustic wave resonator is connected to a parallel arm. For a ladder-type filter, the attenuation is not sufficiently increased in a band higher than the passband if the impedance of the series arm resonator at the anti-resonance frequency is not sufficiently increased.

As for a parallel arm resonator, insertion loss may increase in the passband if the impedance thereof at the anti-resonance frequency is not sufficiently increased.

However, for the surface acoustic wave resonator described in Patent Document 1, the impedance thereof at the anti-resonance frequency may not sufficiently increase. There is also a problem that return loss increases in a frequency band higher than the anti-resonance frequency, for example, at a frequency that is approximately 1.003 times the anti-resonance frequency. For this reason, insertion loss may increase in a band higher than the passband of a ladder-type filter using the surface acoustic wave resonator as a parallel arm resonator.

It is an object of the present invention to provide a surface acoustic wave resonator that not only can solve the above-mentioned disadvantages of the related art and restrain spurious waves due to anharmonic higher-order mode resonance but also can increase the impedance at the anti-resonance frequency, and a ladder-type filter that is formed using the surface acoustic wave resonator as a parallel arm resonator and can reduce insertion loss in a band higher than the passband.

A surface acoustic wave resonator according to the present invention includes: a piezoelectric substrate; an IDT electrode formed on the piezoelectric substrate; and a pair of reflectors provided adjacent to both ends in a surface acoustic wave propagation direction, of the IDT electrode. The IDT electrode includes: first and second bus bars; a plurality of first electrode fingers extending from the first bus bar toward the second bus bar; a plurality of second electrode fingers extending from the second bus bar toward the first bus bar; first dummy electrodes opposed to tips of the first electrode fingers with gaps therebetween and connected to the second bus bar; and second dummy electrodes opposed to tips of the second electrode fingers with gaps therebetween and connected to the first bus bar.

In the present invention, the IDT electrode is subjected to cross-width weighting so that the IDT electrode has a cross width-weighted portion where electrode finger cross widths of the IDT electrode are made smaller as the cross widths move away from a portion having the largest cross width and come closer to both ends in the surface acoustic wave propagation direction, of the IDT electrode, an edge of the first bus bar, the edge being an edge to which the first electrode fingers and the second dummy electrodes are connected, has an inclined portion that is inclined relative to the surface acoustic wave propagation direction so that the edge is disposed a predetermined distance away from an envelope obtained by the cross width weighing, an edge of the second bus bar, the edge being an edge to which the second electrode fingers and the first dummy electrodes are connected, has an inclined portion that is inclined relative to the surface acoustic wave propagation direction so that the edge is disposed a predetermined distance away from the envelope obtained by the cross width weighing, a length of an electrode finger of one of the reflectors, the electrode finger being adjacent to an outermost electrode of the IDT electrode, is approximately equal to a sum of a length of the outermost electrode finger of the IDT electrode and a length of a dummy electrode opposed to a tip of the outermost electrode finger, and if a sum of numbers of electrode fingers and dummy electrodes that a straight line from a tip of at least one electrode finger of the IDT electrode in the surface acoustic wave propagation direction crosses before reaching one of the edge of the first bus bar and the edge of the second bus bar is represented by N, the N is 11 or more, and the number of electrode fingers included in one of the pair of reflectors is approximately N.

The N is preferably 17 or more. In this case, use of the surface acoustic wave resonator as a parallel arm resonator of a ladder-type filter allows further increasing the impedance at the anti-resonance frequency and thereby reducing the return loss at frequencies on the right shoulder of the passband.

In the surface acoustic wave resonator according to the present invention, the above-mentioned N is preferably 30 or less. This allows effectively reducing ripples that appear in a stopband around the edge of a band higher than the passband and thereby increasing electric power resistance.

A ladder-type filter according to the present invention includes series arm resonators and parallel arm resonators. At least two resonators out of the series arm and parallel arm resonators are the surface acoustic wave resonators configured according to the present invention.

The ladder-type filter according to the present invention preferably includes first and second surface acoustic wave resonators disposed so that surface acoustic wave propagation directions thereof are parallel with each other, as the at least two surface acoustic wave resonators. Also, an outer edge of one of the first and second bus bars of one of the first and second surface acoustic wave resonators, the outer edge being opposed to an edge to which one of the first and second electrode fingers and one of the second and first dummy electrodes are connected, is preferably inclined so that the outer edge is a predetermined distance away from the envelope, and the second bus bar of the second surface acoustic wave resonator is preferably located outside the outer edge of the first bus bar of the first surface acoustic wave resonator in a direction perpendicular to the surface acoustic wave propagation direction. This allows further downsizing the ladder-type filter.

### Advantages

In the surface acoustic wave resonator according to the present invention, the edge of the first bus bar to which the first electrode fingers and the second dummy electrodes are connected has the inclined portion that is inclined so that the edge is disposed a predetermined distance away from the envelope obtained by the cross width weighing. Similarly, the edge of the second bus bar to which the second electrode fingers and the first dummy electrodes are connected also has the inclined portion. Accordingly, as in the surface acoustic wave resonator described in Patent Document 1, resonance due to anharmonic higher-order mode does not readily occur and spurious waves due to anharmonic higher-order mode can be reduced. Also, in the present invention, if the sum of the numbers of electrode fingers and dummy electrodes that a straight line from the tip of at least one electrode finger of the above-mentioned IDT electrode in the surface acoustic wave propagation direction crosses before reaching the above-mentioned edge of the first or second bus bar is represented by N, the N is 11 or more, and the number of electrode fingers included in one of the pair of reflectors is approximately N. This allows sufficiently increasing the impedance at the anti-resonance frequency.

Accordingly, use of the surface acoustic wave resonator according to the present invention as a series arm resonator in a ladder-type filter configured using the surface acoustic wave resonator allows increasing the impedance at the anti-resonance frequency and thereby sufficiently increasing the attenuation in a band higher than the passband. Also, return loss in a band higher than the passband can be reduced. Also, use of the above-mentioned surface acoustic wave resonator as a parallel arm resonator allows sufficiently reducing insertion loss in the passband. This allows providing a ladder-type filter having good filter characteristics.

### Brief Description of Drawings

[Fig. 1] Fig. 1 is a plan view schematically showing a piezoelectric resonator according to an embodiment of the present invention.
[Fig. 2] Fig. 2 is a partially notched enlarged plan view of an electrode structure showing a major part of the surface acoustic wave resonator shown in Fig. 1.
[Fig. 3] Fig. 3 is a schematic front sectional view showing a multilayer structure of the surface acoustic wave element according to the embodiment shown in Fig. 1.
[Fig. 4] Figs. 4(a) and 4(b) are drawing showing impedance-frequency characteristics and phase-frequency characteristics of surface acoustic wave resonators according to example experiments and a comparative example.
[Fig. 5] Fig. 5(a) is an impedance Smith chart indicating impedance characteristics of the surface acoustic wave resonators according to the embodiment and comparative example and Fig. 5(b) is a drawing showing return loss-frequency characteristics thereof.
[Fig. 6] Fig. 6(a) is an impedance Smith chart indicating impedance characteristics of the surface acoustic wave resonators in a case where N = 13 and a case where N = 17 and Fig. 6(b) is a drawing showing return loss-frequency characteristics thereof.
[Fig. 7] Fig. 7(a) is an impedance Smith chart indicating impedance characteristics of the surface acoustic wave resonators in the case where N = 17, a case where N = 21, and a case where N = 30 and Fig. 7(b) is a drawing showing return loss-frequency characteristics thereof.
[Fig. 8] Fig. 8(a) and 8(b) are graphs showing impedance-frequency characteristics and phase-frequency characteristics of the surface acoustic wave resonators in the case where N = 30 and a case where N = 70.
[Fig. 9] Fig. 9(a) is an impedance Smith chart indicating impedance characteristics of the surface acoustic wave resonators in the case where N = 30 and the case where N = 70 and Fig. 9(b) is a drawing showing return loss-frequency characteristics thereof.
[Fig. 10] Fig. 10 is a graph showing variations in impedance at the anti-resonance frequency shown when changing the N.
[Fig. 11] Fig. 11 is a schematic plan view showing a ladder-type filter as another embodiment of the present invention.
[Fig. 12] Fig. 12 is a diagram showing a circuit configuration of the ladder-type filter shown in Fig. 11.
[Fig. 13] Fig. 13 is a graph showing a filter characteristic of the ladder-type filter shown in Fig. 11.
[Fig. 14] Fig. 14 is a plan view showing an example of a related-art surface acoustic wave resonator.
[Fig. 15] Fig. 15 is a partially notched plan view showing a major part of the surface acoustic wave resonator shown in Fig. 14.

### Reference Numerals

- 1: surface acoustic wave resonator
- 2: piezoelectric substrate
- 3: IDT electrode
- 4, 5: reflector
- 6: SiO₂ film
- 7: SiN film
- 11: first bus bar
- 12: second bus bar
- 11a, 12a: edge
- 13: first electrode finger
- 14: first dummy electrode
- 15: second electrode finger
- 16: second dummy electrode
- 21: ladder-type filter
- 22: piezoelectric substrate
- B: envelope
- B1, B2: envelope portion
- S1 to S7: series arm resonator
- P1 to P3: parallel arm resonator
- L1, L2: inductance

### Best Mode for Carrying Out the Invention

Hereafter, the present invention will be clarified by describing specific embodiments thereof with reference to the accompanying drawings.

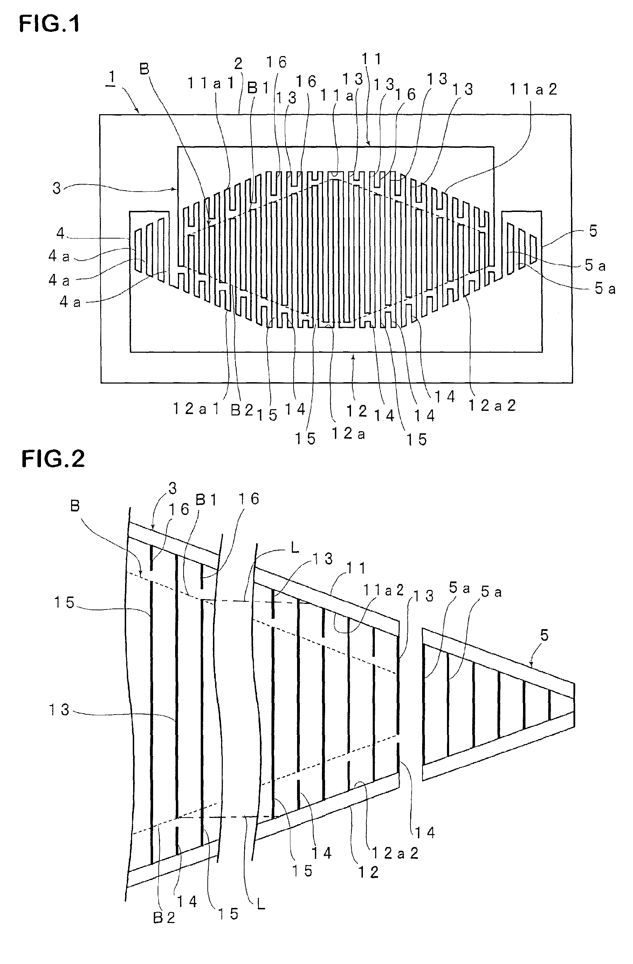

Fig. 1 is a plan view showing a surface acoustic wave resonator according to an embodiment of the present invention. A surface acoustic wave resonator 1 includes a piezoelectric substrate 2. In the present invention, the piezoelectric substrate 2 is a LiNbO₃ substrate having a cut angle 126°. However, the piezoelectric substrate 2 may be made of another piezoelectric monocrystal, such as LiTaO₃ or quartz crystal, or may be made of piezoelectric ceramic, such as lead zirconate titanate ceramic.

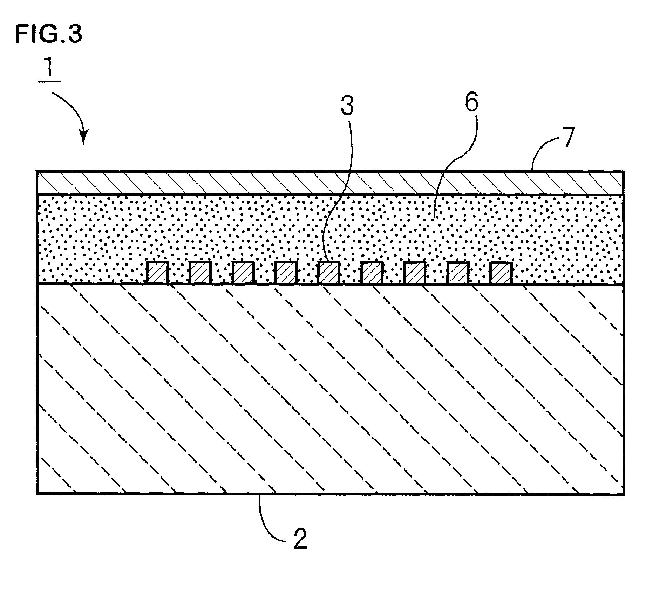

The piezoelectric substrate 2 has an electrode structure shown in Fig. 1 formed thereon. Specifically, an IDT electrode 3 and reflectors 4 and 5 disposed adjacent to both ends of the IDT electrode 3 in the surface acoustic wave propagation directions are formed. Although not shown in Fig. 1, an SiO₂ film 6 and an SiN film 7 are laminated in the presented order in a manner covering the electrode structure including the above-mentioned IDT electrode 3, as shown in Fig. 3.

A feature of the surface acoustic wave resonator 1 according to this embodiment is the electrode structure including the IDT electrode 3 and reflectors 4 and 5.

Specifically, the IDT electrode 3 includes a first bus bar 11 and a second bus bar 12 disposed as opposed to the first bus bar 11. Multiple first electrode fingers 13 extend from an inner edge 11a of the first bus bar 11 toward the second bus bar 12. First dummy electrodes 14 are disposed as opposed to the tips of the first electrode fingers 13 with gaps therebetween. Specifically, the first dummy electrodes 14 extending in the extending direction of the first electrode fingers 13 are disposed as opposed to the tips of the first electrode fingers 13 with the gaps therebetween. Ends of the first dummy electrodes 14 are connected to an inner edge 12a of the second bus bar 12 and the other ends thereof are opposed to the first electrode fingers 13 with the above-mentioned gaps therebetween.

Similarly, second electrode fingers 15 are disposed from the inner edge 12a of the second bus bar 12 toward the first bus bar 11. Second dummy electrodes 16 are disposed as opposed to the tips of the second electrode fingers 15 with gaps therebetween. Ends of the second dummy electrodes 16 are connected to the inner edge 11a of the first bus bar 11 and the other ends thereof are opposed to the tips of the second electrode fingers 15 with the above-mentioned gaps therebetween.

In the above-mentioned IDT electrode 3, the cross widths are weighted. The weighting is performed so that a cross width located at the center of the IDT electrode 3 in the surface acoustic wave propagation direction, that is, in a direction perpendicular to the extending direction of the electrode fingers 13 and 15 is made largest and cross widths closer to both edges of the IDT electrode 3 in the surface acoustic wave propagation direction are made smaller.

Accordingly, an envelope portion B1 adjacent to the first bus bar 11, of an envelope B surrounding the cross width area comes closer to an envelope portion B2 adjacent to the second bus bar 12 as the envelope portion B1 moves from the center of the IDT electrode 3 leftward. Similarly, the envelope portion B1 comes closer to the envelope portion B2 located adjacent to the second bus bar 12 as it moves from the center of the IDT electrode 3 rightward.

In contrast, the center in the surface acoustic wave propagation direction, of the second envelope portion B2 is located most outward in a direction perpendicular to the surface acoustic wave propagation direction. The second envelope portion B2 comes closer to the first envelope portion B1 as it comes closer to both ends thereof in the surface acoustic wave propagation direction.

On the other hand, the inner edge 11a has inclined portions 11a1 and 11a2 so that the distance between the inner edge 11a of the first bus bar 11 and the envelope portion B1 adjacent to the first bus bar 11 is approximately constant. Similarly, the inner edge 12a of the second bus bar 12 also has inclined portions 12a1 and 12a2. The inclined portions 12a1 and 12a2 extend in parallel with the above-mentioned envelope portion B2.

Accordingly, in the IDT electrode 3, the lengths of dummy electrodes and electrode finger portions functioning as reflectors in an area outer than the cross width area in a direction perpendicular to surface acoustic waves are short, as in the surface acoustic wave resonator 1001 described in Patent Document 1. Accordingly, since the area functioning as the above-mentioned reflectors with respect to the group velocity direction of surface acoustic waves is inclined, anharmonic higher-order mode resonance does not readily occur. This allows reducing spurious waves caused by anharmonic higher-order mode resonance.

The reflectors 4 and 5 include multiple electrode fingers 4a and multiple electrode fingers 5a, respectively. These electrode fingers have shorted both ends. The electrode fingers 4a and 5a extend in parallel with the electrode fingers 13 and 15 of the IDT electrode 3.

The length of an electrode finger 4a of the reflector 4 or an electrode finger 5a of the reflector 5 adjacent to an outermost electrode finger 13 or 15 of the IDT electrode 3 in the surface acoustic wave propagation direction is approximately equal to the sum of the length of the outermost electrode finger and the length of a second dummy electrode 14 or first dummy electrode 16 opposed to the tip of the outermost electrode finger.

A feature of the surface acoustic wave resonator 1 according to this embodiment is that spurious waves due to anharmonic higher-order mode can be restrained since the inner edge 11a and inner edge 12a of the first bus bar 11 and second bus bar 12 have the inclined portions 11a1 and 11a2 and inclined portions 12a1 and 12a2 extending approximately in parallel with the envelope portion B1 or envelope portion B2 of the envelope obtained by performing the cross width weighting as described above. Another feature thereof is that, as shown in Fig. 2, the sum of the numbers of electrode fingers and dummy electrodes that a straight line L extending from the tip of at least one electrode finger 13 or 15 in the surface acoustic wave propagation direction crosses before reaching the inner edge 11a of the first bus bar 11 or the inner edge 12a of the second bus bar 12 is represented by N, the N is equal to or more than 11 and the number of the electrode fingers 4a or 5a included in one of the reflectors 4 and 5 is approximately N. This allows sufficiently increasing the impedance at the anti-resonance frequency. Also, in a case where a ladder-type filter used as series arm resonators or parallel arm resonators of a ladder-type filter is formed, characteristics in a band higher than the passband can be improved and return loss can be reduced. This will be described on the basis of specific example experiments.

### Example experiment 1

As the piezoelectric substrate 2, an SiO₂ film was formed on an LiNbO₃ substrate having a cut angle of 126° with a thickness of 220 nm. Subsequently, a resist pattern was formed on the SiO₂ film excluding an electrode formation portion. Then, etching was performed to eliminate the SiO₂ film on the electrode formation portion. Then, a metallic film for forming an electrode was formed on the entire surface of the substrate. As the metallic film for forming an electrode, a multilayer metallic film where metals or alloys, AlCu, Ti, Pt, and NiCr, were laminated in the order presented was formed. The thicknesses of AlCu, Ti, Pt, and NiCr were 100 nm, 10 nm, 80 nm, and 10 nm, respectively. The wavelength determined by the electrode finger pitch of the IDT electrode 3 was 4 µm and the duty ratio was 0.5. The number of electrode finger pairs of the IDT electrode 3 was 88. The cross width of the largest cross width portion was 80 µm and the cross width of the smallest cross width portion was 8 µm. The widths of the gaps located at the tips of the first and second electrode fingers, that is, the sizes of the gaps in a direction perpendicular to the surface acoustic wave propagation direction were 0.4 µm. The lengths of the first dummy electrode 14 and second dummy electrode 16 located at the center of the IDT electrode 3 were zero. The lengths of the dummy electrodes located at both ends in the surface acoustic wave propagation direction, of the IDT electrode 3 were in proportion to the number of dummy electrodes, and were 7.4 µm when the total number of second dummy electrodes was 17. Similarly, for the reflectors 4 and 5, the wavelengths determined by the electrode finger pitch were 4 µm and the duty ratio was 0.5. The number of electrode fingers of the reflectors 4 or 5 was equalized to the N of the IDT electrode 3. The aperture length of the electrode fingers of the reflectors 4 and 5 was equalized to the aperture length of the ends of the IDT electrode 3 in the surface acoustic wave propagation direction, that is, to the sum of the cross width and twice the length of the dummy electrode.

An SiO₂ film having a thickness of 1000 nm was formed in a manner covering the above-mentioned IDT electrode and reflectors. Also, the SiN film 7 that is intended to adjust the frequency and has a thickness of 50 mm was formed.

By performing the above-mentioned surface acoustic wave resonator manufacturing method, surface acoustic wave resonators each having a structure where the number of electrode fingers of the IDT is 88 and having the N of 5, the N of 11, and the N of 19, respectively, were manufactured. For a comparison, a surface acoustic wave resonator having the N of 0 was also manufactured.

The resonance characteristics of the surface acoustic wave resonators obtained in the above-mentioned way were measured.

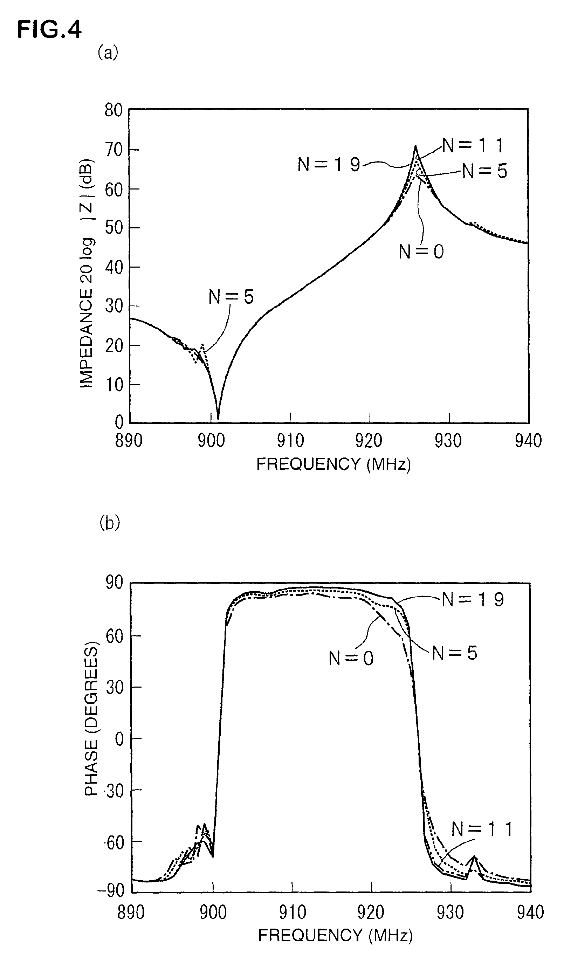

Figs. 4(a) and 4(b) show impedance-frequency characteristics and phase-frequency characteristics of the surface acoustic wave resonators having the N of 0, the N of 5, the N of 11, and the N of 19, respectively.

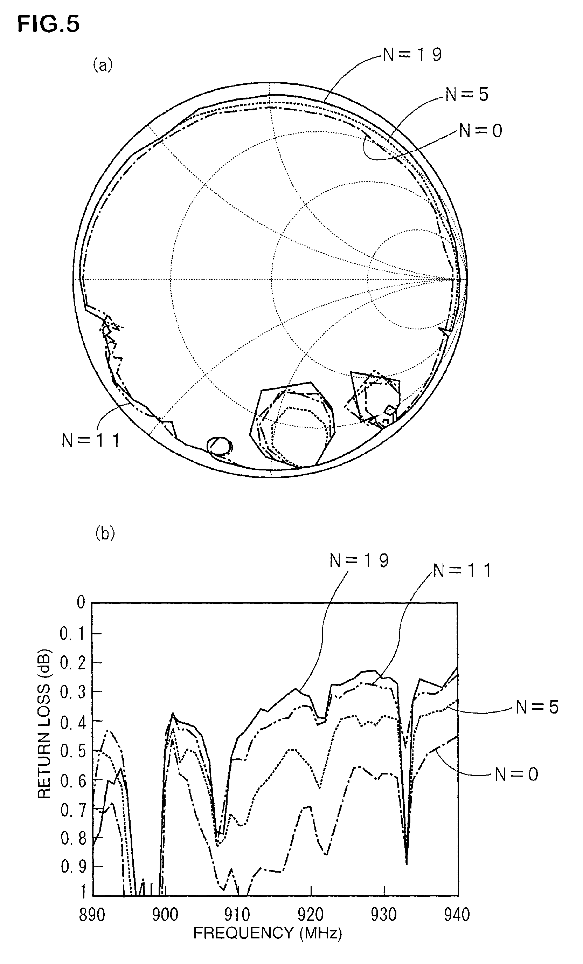

Fig. 5(a) is an impedance Smith chart indicating frequency characteristics of the surface acoustic wave resonators having the N of 0, the N of 5, the N of 11, and the N of 19, respectively, and Fig. 5(b) is a drawing showing return loss-frequency characteristics thereof.

In Figs. 4 and 5, solid lines indicate the results of the case where N = 19, broken lines indicate the results of the case where N = 11, alternate long and short dashed lines indicate the results of the case where N = 5, and chain double-dashed lines indicate the result of the case where N = 0.

From Figs. 4(a) and 4(b) and Figs. 5(a) and 5(b), it is understood that the impedance at the anti-resonance frequency in the case where N = 11 and the case where N = 19 is sufficiently higher than that in the case where N = 0 or case where N = 5. It is also understood that the return loss in the case where N = 11 and the case where N = 19 is smaller than that in the case where N = 0 or case where N = 5. It is also understood that the return loss in the case where N = 19 is smaller than that in the case where N = 11.

### Example experiment 2

An example experiment 2 was performed as in the example experiment 1; however, the number of electrode finger pairs of the IDT electrode 3 was 111, the cross width of the largest cross width portion was 100 µm, and the cross width of the smallest cross width portion was 10 µm. Surface acoustic wave resonators having the N of 13, 17, 21, 30, and 70 were manufactured. For a comparison, a surface acoustic wave resonator having the N of 0 was manufactured. With respect to the other matters, the example experiment 2 was the same as the example experiment 1.

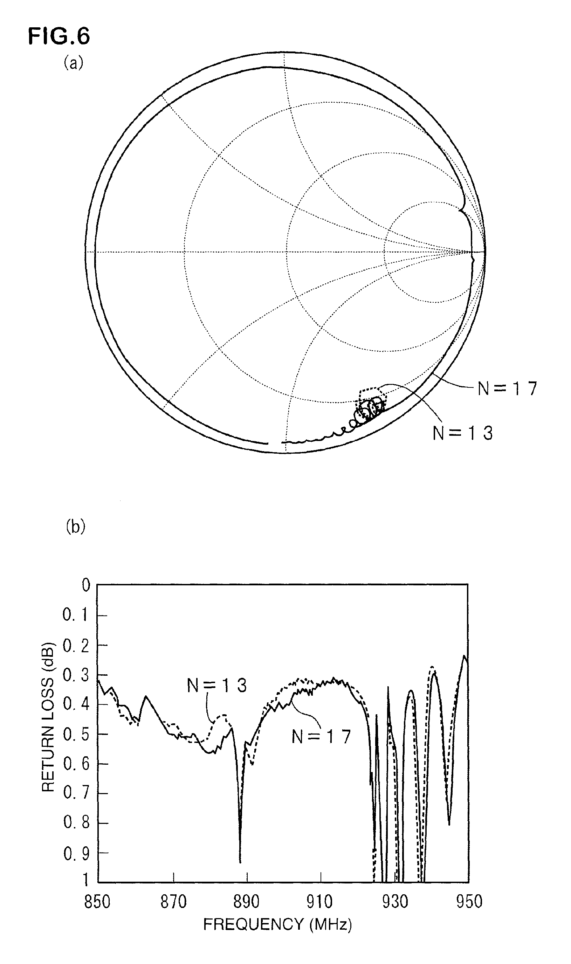

Fig. 6(a) is an impedance Smith chart indicating frequency characteristics of the surface acoustic wave resonators having the Ns of 13 and 17 and Fig. 6(b) is a drawing showing return loss-frequency characteristics thereof.

In Figs. 6(a) and 6(b), solid lines indicate the results of the case where N = 13 and broken lines indicate the result of the case where N = 17.

From Figs. 6(a) and 6(b), it is understood that the return loss in the case where N = 17 is much smaller than that in the case where N = 13. Accordingly, from the results shown in Fig. 5(a) and Fig. 6(b), it is understood that the N is preferably 17 or more and thus the return loss can be further reduced.

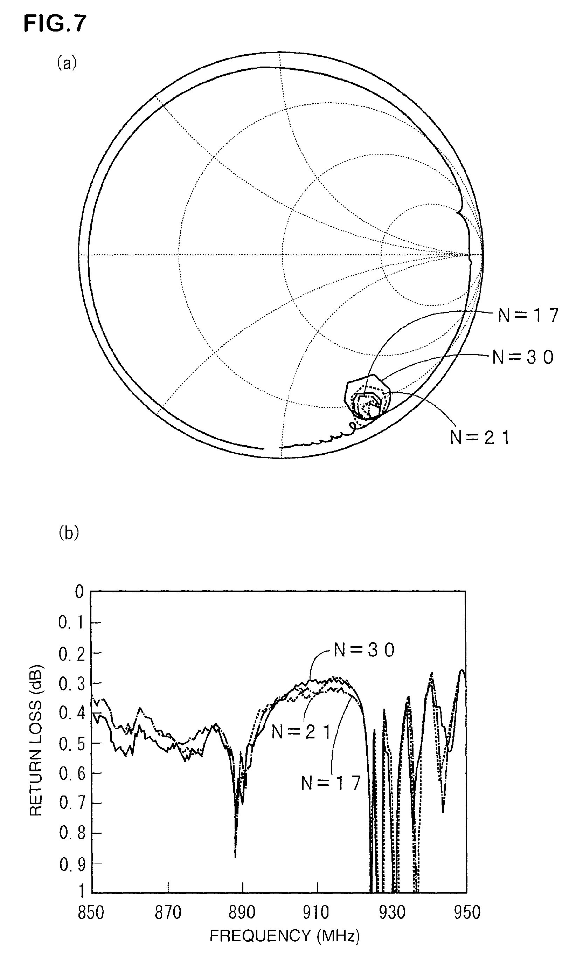

Also, as shown in Figs. 7(a) and 7(b), there was almost no difference in characteristic among the case where N = 17, the case where N = 21, and the case where N = 30, that is, in the range where the N is 17 to 30.

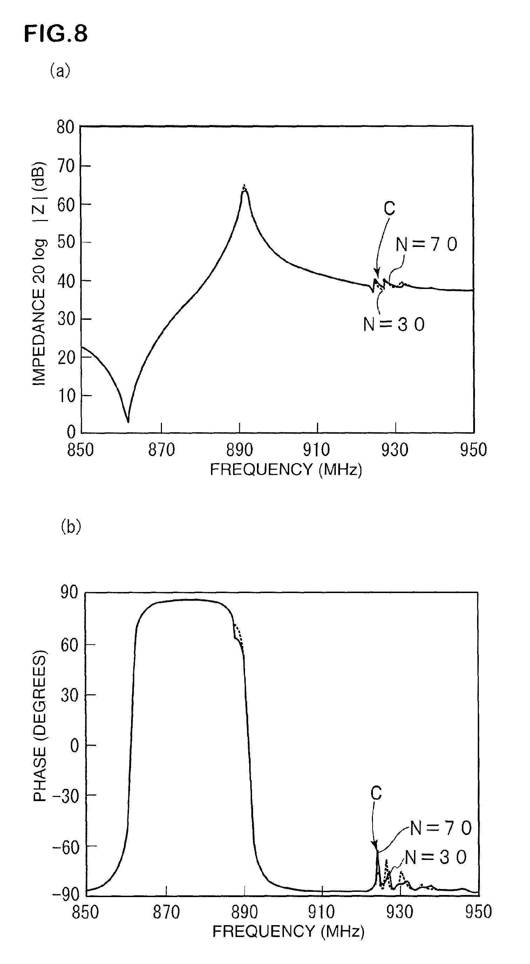

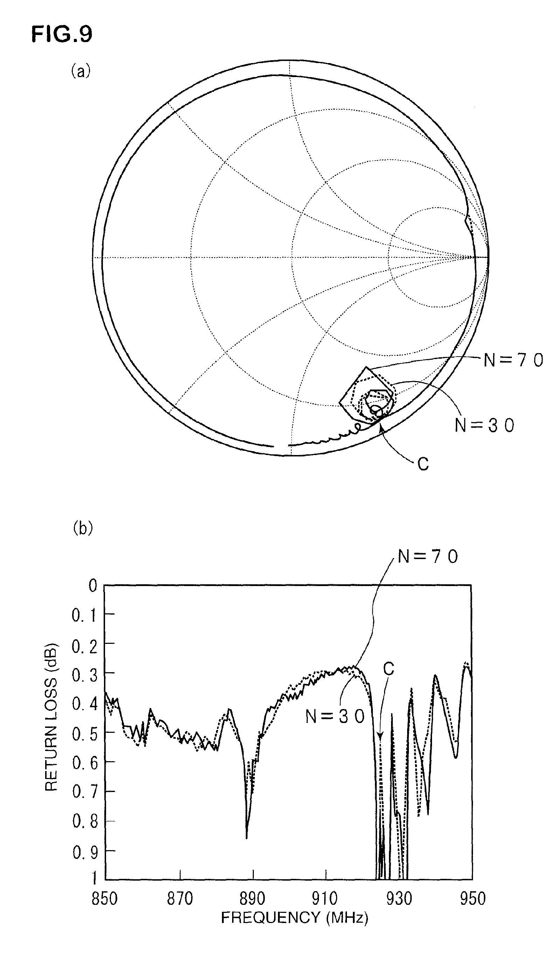

Figs. 8(a) and 8(b) show impedance-frequency characteristics and phase-frequency characteristics of the surface acoustic wave resonators having the Ns of 30 and 70. Fig. 9(a) is an impedance Smith chart indicating impedance characteristics of the surface acoustic wave resonators having the Ns of 70 and 30 and Fig. 9(b) is a drawing showing return loss-frequency characteristics thereof.

From Figs. 8(a) and 8(b) and Figs. 9(a) and 9(b), it is understood that, as shown an arrow C, ripples around 925 to 935 MHz are more in the case where N = 70 than in the case where N = 30. Accordingly, for example, if the surface acoustic wave resonator where N = 70 is used as a parallel arm resonator of a ladder-type filter, such an increase in ripple may cause a reduction in electric power resistance. Accordingly, preferably, it is desirable to set the N to 30 or less to reduce the above-mentioned ripples.

As seen, by setting the N to 11 or more in the surface acoustic wave resonator 1, the impedance at the anti-resonance frequency can be increased sufficiently. Accordingly, if the surface acoustic wave resonator 1 thus configured is used as a series arm resonator of a ladder-type filter, the attenuation in a band higher than the passband can be sufficiently increased. If such a resonator is used as a parallel arm resonator, an increase in insertion loss in the passband can be restrained.

Also, it is understood that if the N is set to 17 or more, the return loss around the passband in a band higher than the anti-resonance frequency can be reduced and thus a ladder-type filter having much better filter characteristics can be obtained.

Also, it is understood that by setting the N to 30 or less as described above, ripples in a band higher than the anti-resonance frequency can be reduced and, thus, if the surface acoustic wave resonator thus configured is used as a parallel arm resonator, out-of-band ripples around the edge of a band higher than the passband of a ladder-type filter can be favorably reduced.

Accordingly, the surface acoustic wave resonator obtained according to the present invention is favorably used as a parallel arm resonator or series arm resonator of a ladder-type filer.

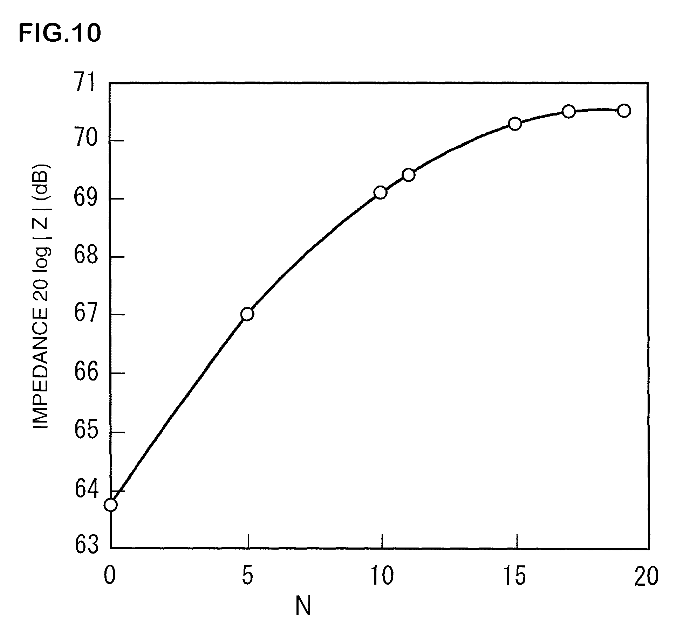

Fig. 10 is a graph showing variations in impedance of the surface acoustic wave resonator at the anti-resonance frequency shown when changing the above-mentioned N. From Fig. 10, it is understood that when the N is 11 or more, the impedance can be sufficiently increased and, in particular, by setting the N to 15 or more, more preferably, to 17 or more, the impedance at the anti-resonance frequency can be further increased.

### Embodiment of Ladder-type Filter

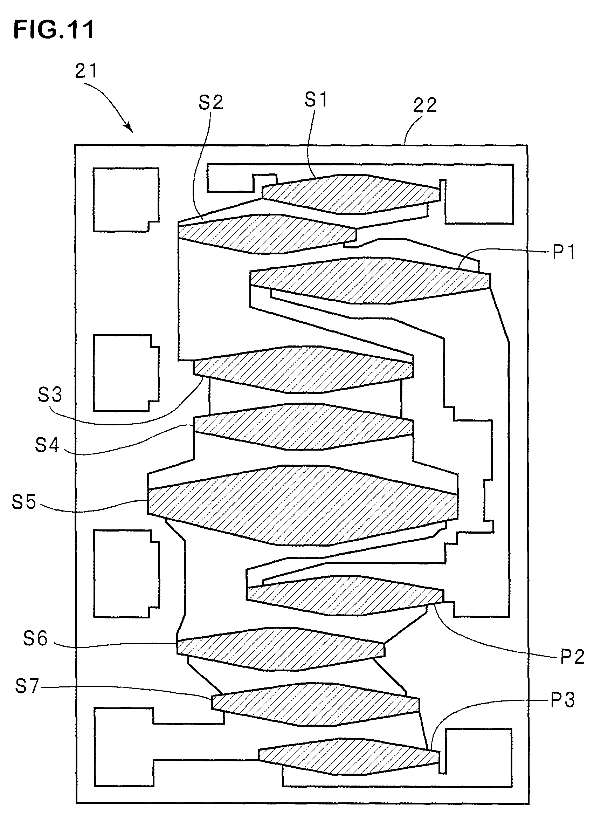

Fig. 11 is a schematic plan view showing a ladder-type filter as another embodiment of the present invention. The electrode structure shown in Fig. 1 is formed on hatched portions shown in Fig. 11. The ladder-type filter according to this embodiment is used as a GSM transmission filter having a center frequency of 897.5 MHz and a passband of 880 to 915 MHz. Note that the SiO₂ film and SiN film formed in the above-mentioned surface acoustic wave resonator are omitted in Fig. 11. However, the SiO₂ film 6 or SiN film 7 does not always need to be formed in the surface acoustic wave resonator according to the present invention and the ladder-type filter formed using the surface acoustic wave resonator.

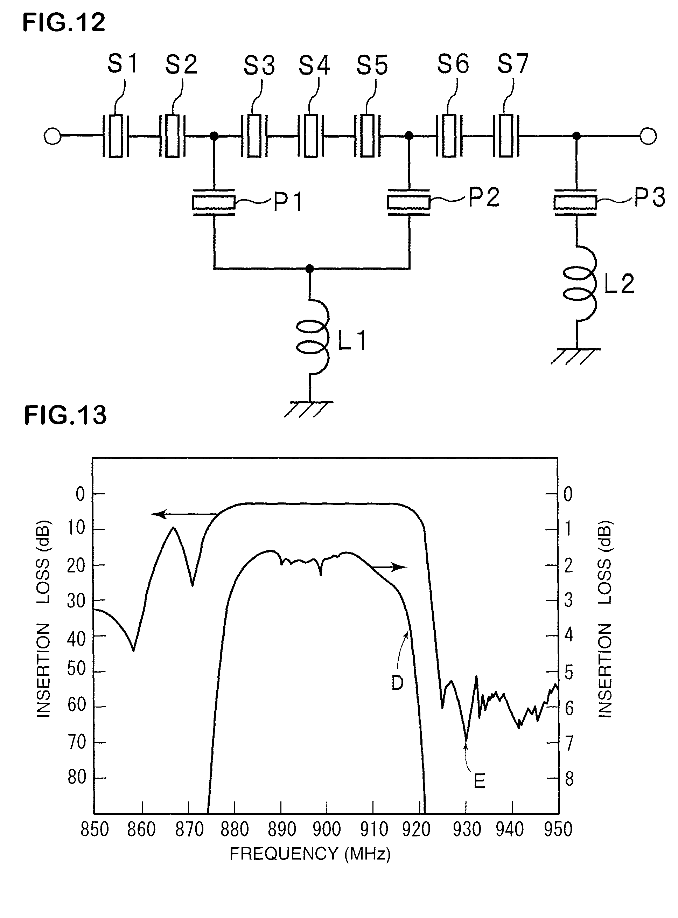

As shown in Fig. 11, in a ladder-type filter 21, series arm resonators S1 to S7 are formed on a piezoelectric substrate 22. Also, parallel arm resonators P1 to P3 are formed on the piezoelectric substrate 22. By connecting the series arm resonators S1 to S7 and parallel arm resonators P1 to P3 as shown in Fig. 12, the ladder-type filter 21 is formed. Inductance L1 shown in Fig. 12 is formed by an inductance element inserted between the parallel arm resonators P1 and P2 and a ground potential or an inductance formed by a wiring line. Similarly, an inductance L2 inserted between the parallel arm resonator P3 and a ground potential is formed by an independently connected inductance element or an inductance formed by a wiring line.

In the ladder-type filter 21 as described above, the series arm resonators S1 to S7 and parallel arm resonators P1 to P3 are formed using surface acoustic wave resonators formed according to the present invention. Thus, the impedances of the surface acoustic wave resonators at the anti-resonance frequency are sufficiently increased. This allows improving attenuation characteristics in a band higher than the passband, as well as reducing the return loss in an attenuation band of a band higher than the passband. Thus, good filter characteristics can be obtained.

Fig. 13 is a graph showing filter characteristics of the above-mentioned ladder-type filter. From Fig. 13, it is understood that good filter characteristics are exhibited on the right shoulder of the passband as shown by an arrow D.

It is also understood that sufficient attenuations are obtained in a band higher than the passband as shown by an arrow E.

### Modification

In the surface acoustic wave resonator 1 according to the above-mentioned embodiment, there is formed a single cross width-weighted portion where the cross widths become smaller as they move away from the largest cross width portion and come closer to both ends of the IDT electrode; however, such cross width-weighted portions may be disposed in a multiple number in the surface acoustic wave propagation direction. In other words, if the above-mentioned cross width-weighted portion of the surface acoustic wave resonator 1 is considered as one cycle, cross width-weighted portions may be provided so that multiple cycles are provided.

Also, in the above-mentioned surface acoustic wave resonator 1, the edge 11a of the first bus bar and the edge 12a of the second bus bar 12 have the inclined portions 11a1 and 11a2 and inclined portions 12a1 and 12a2, respectively, and non-inclined portions are provided between the inclined portions 11a1 and 11a2 and between the inclined portions 12a1 and 12a2; however, the non-inclined portions do not always need to be provided. In other words, the edges 11a and 12a may be formed so that the edges each include only two inclined portions extending from the largest cross width portion toward both ends of the IDT electrode in the surface acoustic wave propagation direction.

Also, in the surface acoustic wave resonator 1 according to the above-mentioned embodiment, the SiO₂ film 6 is laminated to improve frequency-temperature characteristics; however, the frequency-temperature coefficient may be reduced in a similar manner by forming an insulating film other than SiO₂. While the SiN film 7 is laminated to adjust the frequency, the frequency may be adjusted by forming an insulating film, a metallic film, or the like other than the SiN film 7.

Also, the SiO₂ film or SiN film do not always need to be formed.

Also, in the surface acoustic wave resonator 1 according to the above-mentioned embodiment, the cross widths are weighted so that the cross width located at the center of the IDT electrode in the surface acoustic wave propagation direction is made largest and the cross widths closer to both ends thereof are made smaller; however, such a cross width-weighted portion may be formed in multiple cycles.

Also, in the above-mentioned embodiment, the cross widths of the reflectors 4 and 5 are weighted so that the lengths of the electrode fingers thereof vary along the surface acoustic wave propagation direction; however, normal reflectors whose electrode fingers have a constant length may be used.

## Claims

1. A surface acoustic wave resonator comprising:
a piezoelectric substrate;
an IDT electrode formed on the piezoelectric substrate; and
a pair of reflectors provided adjacent to both ends in a surface acoustic wave propagation direction, of the IDT electrode, wherein
the IDT electrode includes:
first and second bus bars;
a plurality of first electrode fingers extending from the first bus bar toward the second bus bar;
a plurality of second electrode fingers extending from the second bus bar toward the first bus bar;
first dummy electrodes opposed to tips of the first electrode fingers with gaps therebetween and connected to the second bus bar; and
second dummy electrodes opposed to tips of the second electrode fingers with gaps therebetween and connected to the first bus bar,
the IDT electrode is subjected to cross-width weighting so that the IDT electrode has a cross width-weighted portion where electrode finger cross widths of the IDT electrode are made smaller as the cross widths move away from a portion having the largest cross width and come closer to both ends in the surface acoustic wave propagation direction, of the IDT electrode,
an edge of the first bus bar, the edge being an edge to which the first electrode fingers and the second dummy electrodes are connected, has an inclined portion that is inclined relative to the surface acoustic wave propagation direction so that the edge is disposed a predetermined distance away from an envelope obtained by the cross width weighing,
an edge of the second bus bar, the edge being an edge to which the second electrode fingers and the first dummy electrodes are connected, has an inclined portion that is inclined relative to the surface acoustic wave propagation direction so that the edge is disposed a predetermined distance away from the envelope obtained by the cross width weighing,
a length of an electrode finger of one of the reflectors, the electrode finger being adjacent to an outermost electrode finger of the IDT electrode, is approximately equal to a sum of a length of the outermost electrode finger of the IDT electrode and a length of a dummy electrode opposed to a tip of the outermost electrode finger, and
if a sum of numbers of electrode fingers and dummy electrodes that a straight line from a tip of at least one electrode finger of the IDT electrode in the surface acoustic wave propagation direction crosses before reaching one of the edge of the first bus bar and the edge of the second bus bar is represented by N, the N is 11 or more, and the number of electrode fingers included in one of the pair of reflectors is approximately N.

2. The surface acoustic wave resonator according to Claim 1, wherein the N is 17 or more.

3. The surface acoustic wave resonator according to any one of Claims 1 and 2, wherein
the N is 30 or less.

4. A ladder-type filter comprising:
series arm resonators; and
parallel arm resonators, wherein
at least two resonators of the series arm resonators and the parallel arm resonators are surface acoustic wave resonators according to any one of Claims 1 to 3.

5. The ladder-type filter according to Claim 4, wherein
the ladder-type filter includes first and second surface acoustic wave resonators disposed so that surface acoustic wave propagation directions thereof are parallel with each other, as the at least two surface acoustic wave resonators,
an outer edge of one of the first and second bus bars of one of the first and second surface acoustic wave resonators, the outer edge being opposed to an edge to which one of the first and second electrode fingers and one of the second and first dummy electrodes are connected, is inclined so that the outer edge is a predetermined distance away from the envelope, and the second bus bar of the second surface acoustic wave resonator is located outside the outer edge of the first bus bar of the first surface acoustic wave resonator in a direction perpendicular to the surface acoustic wave propagation direction.
